(19)

Europäisches
Patentamt
European
Patent Office
Office européen
des brevets

(11)  EP 2 613 325 B1

(12)  # EUROPEAN PATENT SPECIFICATION

(45) Date of publication and mention
of the grant of the patent:
**14.02.2018 Bulletin 2018/07**

(51) Int Cl.:
**G21D 1/02** *(2006.01)*      **G21D 3/00** *(2006.01)*
**G06F 17/50** *(2006.01)*

(21) Application number: **12199523.7**

(22) Date of filing: **27.12.2012**

(54) **Method of reducing errors when calculating the shape annealing function (SAF) of an ex-core detector of a nuclear power plant**

Verfahren zur Verringerung der Fehler beim Berechnen der Formausgleichsfunktion (SAF) eines Ex-Core-Detektors eines Kernkraftwerks

Procédé de réduction des erreurs lors du calcul de la fonction de compensation de forme (SAF) du détecteur ex-core d'une centrale nucléaire

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.01.2012 KR 20120002462**

(43) Date of publication of application:
**10.07.2013 Bulletin 2013/28**

(73) Proprietor: **Kepco Engineering & Construction Company, Inc.**
**Gyeonggi-Do 449-713 (KR)**

(72) Inventor: **Kim, Hyeong Heon**
**302-120 Daejeon (KR)**

(74) Representative: **J A Kemp**
**14 South Square**
**Gray's Inn**
**London WC1R 5JJ (GB)**

(56) References cited:
**US-A- 4 318 778      US-A- 4 774 050**
**US-A1- 2005 105 675      US-A1- 2010 104 059**

• **HIROSHI TOCHIHARA ET AL: "Reevaluation of Spatial Weighting Factors for Ex-Core Neutron Detectors", NUCLEAR TECHNOLOGY,, vol. 58, 1 August 1982 (1982-08-01), pages 310-317, XP009193525,**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

CROSS-REFERENCE TO RELATED PATENT APPLICATIONS

This application claims the benefit of Korean Patent Application No. 10-2012-0002462, filed on January 9, 2012, in the Korean Intellectual Property Office .

BACKGROUND OF THE INVENTION

1. Field of the Invention

The present invention relates to a method of reducing errors when calculating a shape annealing function (SAF) of an ex-core detector of a nuclear power plant. Specifically, a Monte Carlo analysis is applied to a 3-dimensional model of a nuclear reactor structure and an ex-core detector.

2. Description of the Related Art

In a nuclear power plant using a core protection calculator, a measurement signal of an ex-core detector installed outside a pressure vessel is used to identify a power distribution of a core. To determine whether an ex-core detector accurately reflects a state of a core, the measurement signal of the ex-core detector is compared with a measurement signal of an in-core detector installed inside the core. It must then be proven that a difference between the two measurement signals is within a predetermined limit.

A shape annealing function (SAF) transfers a signal of the in-core detector to the ex-core detector during a power ascension test performed in a plant startup test period. In other words, SAF is a transfer function that transfers a measured value of the in-core detector to the ex-core detector. SAF is calculated by analyzing the transport and diffusion of neutrons from the core to the ex-core detector by using a particle transport computer code. SAF is determined by geometric shapes and materials of the core, the ex-core detector and structures therebetween. Until recently, SAF has been calculated by a 2-dimensional deterministic method.

According to the 2-dimensional deterministic method, neutron transport behavior is expressed by a mathematical equation, and the mathematical equation is approximated by numerical analysis to obtain a solution thereof using computer code. Analyzing a 3-dimensional nuclear reactor by using the 2-dimensional deterministic method reduces a calculation time. However, in exchange for reduced calculation time, an error in the calculation of SAF is likely to occur due to various approximations applied. Such an error further increases in proportion to geometrical irregularity of the ex-core detector.

US patent application document US 2010/104059 A1 discloses an other method of reducing errors when calculating a shape annealing function (SAF) of an ex-core detector of a nuclear power plant.

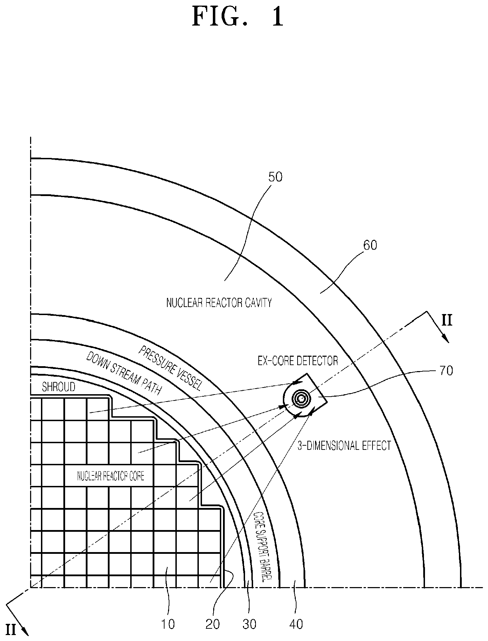

FIG. 1 is a horizontal quarter cross-sectional view of a nuclear reactor. Referring to FIG. 1, a model for calculating SAF includes a nuclear reactor core 10, a shroud 20, a core support barrel 30, a pressure vessel 40, a nuclear reactor cavity 50, a concrete shield 60, and an ex-core detector 70.

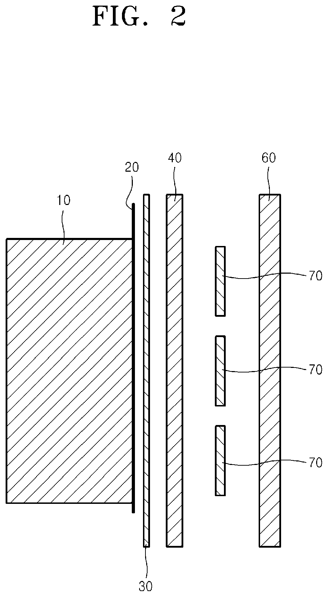

FIG. 2 is an axial (or vertical) cross-sectional view taken along line II-II of FIG. 1. According to a conventional 2-dimensional deterministic method, SAF is calculated using the 2-dimensional (radial direction and axial direction) coordinates system illustrated in FIG. 2. A core is approximated to a cylinder, and an ex-core detector is approximately ring shaped and surrounds the core in the nuclear reactor cavity.

According to the 2-dimensional model, as illustrated in FIG. 2, neutrons emitted from the core and entering through only the front side of the ex-core detector facing the core are taken into consideration, while neutrons passing through the lateral sides of the ex-core detector are not.

Thus, when an in-core detector signal is transferred to the ex-core detector by the 2-dimensional SAF, errors are further generated and thus a difference between a measured value of the ex-core detector and an estimated value of the in-core detector deviates from a design specification.

SUMMARY OF THE INVENTION

The present invention provides a method of reducing errors when calculating a shape annealing function (SAF) of an ex-core detector of a nuclear power plant by using a 3-dimensional Monte Carlo analysis.

According to an aspect of the present invention, there is provided a method of reducing errors when calculating a shape annealing function (SAF) of an ex-core detector of a nuclear power plant, the method comprising: 3-dimensionally modeling elements of the nuclear power plant, the elements of the nuclear power plant comprising: a nuclear reactor core, an ex-core detector disposed in a nuclear reactor cavity, and nuclear reactor structures arranged between the nuclear reactor core and the ex-core detector; predicting an arrival position for emitted neutrons, by using a Monte Carlo method when a neutron source arranged at the ex-core detector and neutrons emitted towards the nuclear reactor core, the predicted arrival position indicating where the emitted neutron will arrive at the nuclear reactor core; and producing an SAF based on a correlation between the neutron source arranged at the ex-core detector and the predicted arrival position of the neutrons in the reactor core.

The method may include in the 3-dimentionally modeling of the elements wherein a plurality of ex-core detectors are disposed in the nuclear reactor cavity, one of the plurality of ex-core detectors is disposed at each of an upper portion, a middle portion, and a lower portion of the nuclear reactor cavity, in a vertical direction of the nuclear reactor core, predicting of the arrival position for the emitted neutrons is performed for the ex-core detectors disposed at each of the upper portion, the middle portion, and the lower portion of the nuclear reactor cavity, and the nuclear reactor core is divided into a plurality of slices in a horizontal direction and it is predicted on which slice the emitted neutrons will arrive.

BRIEF DESCRIPTION OF THE DRAWINGS

The above and other features and advantages of the present invention will become more apparent by referring to exemplary embodiments thereof with reference to the attached drawings in which:

FIG. 1 is a horizontal quarter cross-sectional view of a nuclear reactor that schematically illustrates an arrangement of a core of a nuclear reactor and an ex-core detector;
FIG. 2 is a cross-sectional view taken along line II-II of FIG. 1;
FIG. 3 schematically illustrates a 3-dimensional model of one-quarter of a nuclear reactor;
FIG. 4 schematically illustrates an adjoint transport calculation; and
FIG. 5 is a graph showing a comparison result between SAF according to a 2-dimensional deterministic method and SAF according to the present invention.

DETAILED DESCRIPTION OF THE INVENTION

The attached drawings for illustrating exemplary embodiments of the present invention are referred to in order to gain a sufficient understanding of the present invention, the merits thereof, and the objectives accomplished by the implementation of the present invention. Hereinafter, the present invention will be described in detail by explaining exemplary embodiments of the invention with reference to the attached drawings. Like reference numerals in the drawings denote like elements.

The present invention relates to a method of reducing errors when calculating a shape annealing function (SAF) used to verify an ex-core detector of a nuclear power plant using a core protection calculator. The verification of an ex-core detector is performed by comparing measured values of an in-core detector and the ex-core detector. SAF enables the comparison by transferring the measured value of the in-core detector to the ex-core detector.

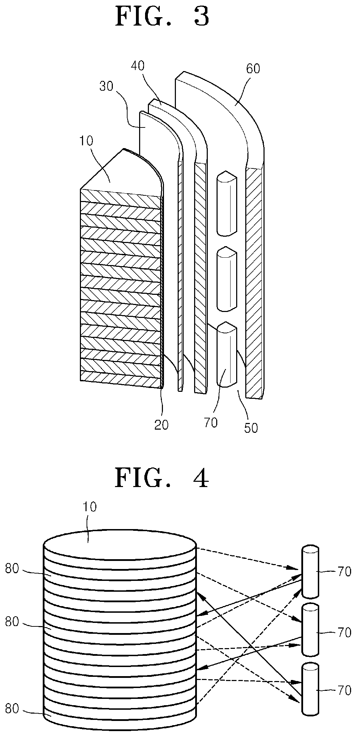

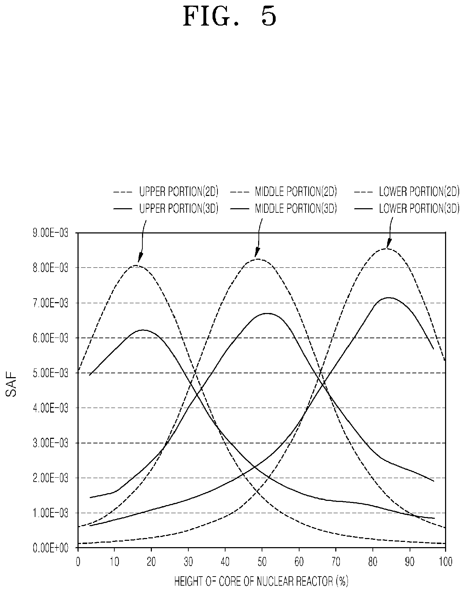

FIG. 3 schematically illustrates a 3-dimensional model of one-quarter of a nuclear reactor. FIG. 4 schematically illustrates an adjoint transport calculation. FIG. 5 is a graph showing a comparison result between SAF by a 2-dimensional deterministic method and SAF according to the present invention.

According to an embodiment of the present invention, the method of reducing errors when calculating SAF of an ex-core detector of a nuclear power plant includes 3-dimensional modeling, neutron behavior determination, and SAF calculation.

Referring to FIG. 3, a nuclear reactor core 10, an ex-core detector 70 arranged in a nuclear reactor cavity 50, and nuclear reactor structures arranged between the nuclear reactor core 10 and the ex-core detector 70 are modeled 3-dimensionally. In detail, the 3-dimensional model includes the nuclear reactor core 10, a shroud 20, a core support barrel 30, a pressure vessel 40, the nuclear reactor cavity 50, a concrete shield 60, and the ex-core detector 70.

According to the present embodiment, a 3-dimensional model is built in which ex-core detectors 70 are arranged vertically with respect to the nuclear reactor core 10 in an upper portion, a middle portion, and a lower portion of the nuclear reactor cavity 50.

The vertically arranged ex-core detectors 70 are symmetrically arranged in the nuclear reactor cavity 50 with respect to the axial center of the nuclear reactor core 10. A total of twelve (12) ex-core detectors 70 are arranged in the nuclear reactor. In each quarter of the nuclear reactor, three (3) ex-core detectors 70 are arranged.

As the nuclear reactor structures including the ex-core detector 70 are modeled in 3 dimensions, the approximation of curved and linear surface structures of the nuclear reactor is avoided so that a geometrical modeling error may be reduced.

In the neutron behavior determination, a simulation is performed wherein a neutron source is arranged at the ex-core detector 70, neutrons are emitted toward the nuclear reactor core 10, and an arrival position of at least one neutron that arrives in the nuclear reactor core 10 is predicted by a Monte Carlo analysis.

According to the present embodiment, the neutron behavior determination is performed for each of the ex-core detectors 70.

Also, according to the present embodiment, the nuclear reactor core 10 is divided into a plurality of slices in the horizontal direction, and the slice that neutrons reach is determined.

To calculate SAF, analyzing neutron transport behavior from the nuclear reactor core 10 to the ex-core detector 70 includes forward transport calculation and adjoint transport calculation.

Forward transport calculation simulates actual neutron transport behavior. Adjoint transport calculation simulates the flow of neutrons in a direction opposite to their actual flow direction.

Referring to FIG. 4, forward transport calculation includes simulating the flow of neutrons (indicated by a dotted line) from the nuclear reactor core 10 toward the ex-core detector 70. In contrast, adjoint transport calculation simulates the flow of neutrons (indicated by a solid line) from the ex-core detector 70 toward the nuclear reactor core 10.

According to the present embodiment, as described above, the neutron behavior determination uses adjoint transport calculation.

In forward transport calculation, a neutron source is placed in the nuclear reactor core 10 and the number of calculations is set according to the number of slices the nuclear reactor core 10 is divided into in an axial direction. The nuclear reactor core 10 is typically divided into 15 or more slices in an actual design.

In other words, in forward transport calculation, 15 or more calculations are needed based on the 15 or more slices of the nuclear reactor core 10. In contrast, in adjoint transport calculation, calculation is performed assuming that an adjoint neutron source is disposed at each of the three ex-core detectors 70, and thus calculation time is only three times that of a single transport calculation

SAF is produced using a correlation between the neutrons arriving at the nuclear reactor core 10 and the neutron source placed at the ex-core detector 70.

When using the adjoint transport calculation method to calculate SAF, forward transport calculation, and adjoint transport calculation of a target system considered in the transport calculation are defined as follows.

$$H\Psi = Q$$

$$H^+\Psi^+ = \Sigma_d$$

$H\Psi = Q$ is an equation for forward transport calculation, and $H^+\Psi^+ = \Sigma_d$ is an equation for adjoint transport calculation.

In the above equations, "H" and "$H^+$" are forward and adjoint transport operators, respectively, "$\Psi$" and "$\Psi^+$" are forward and adjoint flux, respectively, "Q" is a forward source term(nuclear reactor core neutron), and "$\Sigma_d$" is an adjoint source of a cross-sectional portion of the nuclear ex-core detector.

An ex-core detector reaction function R is given below, wherein "< >" is an inner product.

$$R = <\Psi^+ Q>$$

To calculate SAF, the adjoint flux $\Psi^+$ is solved for by using the equation for adjoint transport calculation $H^+\Psi^+ = \Sigma_d$. The ex-core detector reaction function R is then calculated by multiplying the forward source term Q to the adjoint flux $\Psi$+. Independent adjoint transport calculations are performed three times to obtain the adjoint flux $\Psi^+$ for each of the ex-core detectors 70 vertically aligned in an axial direction at the upper, middle, and lower portions in the cavity 50 .

On the other hand, in forward transport calculation, the forward source term Q is an isotropic fission source of a unit strength located in nuclear reactor core $r_i$, and is expressed as follows.

$$Q(r, \Omega, E) = (1/4\pi)\chi(E)\delta(r-r_i)$$

In the above equation, "$\chi(E)$" is a U-235 fission neutron spectrum and "$\delta(r-r_i)$" is a 3-dimensional Dirac delta function.

The reaction of the ex-core detector 70 with respect to the forward source term Q located in the nuclear reactor core nuclear fuel region $r_i$ is expressed as follows.

$$R(r_i) = (1/4\pi)\int dE \int d\Omega \chi(E) \Psi^+(r_i, E, \Omega)$$

In the above equation, "$\Psi^+$" indicates the adjoint flux at the position $r_i$ with respect to the adjoint source $\Sigma_d$.

The ex-core detector 70 is provided as a U-235 fission chamber and thus the adjoint source $\Sigma_d$ in the adjoint transport calculation is proportional to a U-235 fission reaction rate. Accordingly, a fission microscopic cross-section of U-235 may be used as the adjoint source $\Sigma_d$ in the adjoint transport calculation.

Monte Carlo analysis is used to predict, one by one, paths of each of a plurality of neutrons. In the present embodiment, as described above, a neutron source is placed at the ex-core detector 70, and the path of each neutron flowing from the neutron source toward the nuclear reactor core 10 is predicted.

In the calculation using Monte Carlo analysis, a detector is present at each of the ex-core detectors 70 arranged at the upper, middle, and lower portions, and the nuclear reactor core 10 may be divided into slices in any axial direction. In a slice j, the reaction of a detector at any of the ex-core detectors 70 with respect to the neutron source is given as follows.

$$R^k_j = \Sigma_{ri \square j} R^k(r_i)$$

In the above equation, "$R^k(r_i)$" denotes a degree of reaction of the $k^{th}$ detector, where "k" is a natural number selected from 1, 2, and 3 by the neutron source located at position $r_i$ in the nuclear reactor core 10. In the adjoint transport calculation, the degree of reaction "$R^k(r_i)$" is a value obtained from the nuclear reactor core 10 $r_i$ when the adjoint source is located at the detector k.

An SAF calculation formula may be expressed as follows by using the definition of SAF with the above reaction function.

$$SAF^k_j = (R^k_j / (\Sigma^3_{k=1}\Sigma_j R^k_j))/(((z_{j+1}-z_j)/H)\times 100)$$

In the above equation, "j" is an index of a slice j in an axial direction of an area of the nuclear reactor core 10, where "j" is a natural number between 1 to 15 in the present embodiment, "k" is an index of each of the upper, middle, and lower ex-core detectors 70, "$R^k_j$" is a reaction of a particular detector k with respect to the slice j, and "H" is the height of the nuclear reactor core 10.

According to the present embodiment, nuclear reactor structures including the ex-core detector 70 are modeled 3-dimensionally, and a Monte Carlo analysis is used in adjoint transport calculation. As a result, geometrical structures are modeled without structural approximation of curved and linear surfaces of the nuclear reactor structures, and errors in calculated SAF are reduced. The present embodiment takes into consideration neutrons passing through the lateral surface of an ex-core detector, thus additionally solving the problems of SAF calculation encountered when using the conventional 2-dimensional deterministic method.

The use of Monte Carlo analysis by the present embodiment provides an optimal prediction of actual neutron transport behavior in a nuclear reactor, thus further reducing errors when calculating SAF.

FIG. 5 is a graph showing a comparison result between SAF according to a 2-dimensional deterministic method and SAF according to the present invention. SAF is shown according to the 2-dimensional deterministic method (indicated by a dotted line) and according to the present invention (indicated by a solid line), when the ex-core detectors 70 are arranged vertically with respect to the nuclear reactor core 10 in an upper portion, middle portion, and a lower portion of the nuclear cavity 50.

As shown in FIG. 5, it is seen that SAF according to the present invention has been widen with a lower peak reflecting a 3-dimensional effect in comparison to the SAF according to the 2-dimensional deterministic method.

SAF calculation method is introduced to solve a problem that a difference between measured ex-core signal and predicted in-core detector signal deviates a test criterion during an ex-core detector verification test of a nuclear power plant. Since in Monte Carlo analysis neutron transport behavior is simulated without any numerical approximations and a target object is modeled 3-dimensionally, thus SAF with reduced errors may be provided.

While this invention has been particularly shown and described with reference to exemplary embodiments thereof, it will be understood by those skilled in the art that various changes in form and details may be made therein without departing from the scope of the invention as defined by the appended claims.

**Claims**

1.  A computer-implemented method of reducing errors when calculating a shape annealing function (SAF) of an ex-core detector of a nuclear power plant, the method comprising:

    3-dimensionally modeling elements of the nuclear power plant, the elements of the nuclear power plant comprising:

    a nuclear reactor core,
    an ex-core detector disposed in a nuclear reactor cavity, and
    nuclear reactor structures arranged between the nuclear reactor core and the ex-core detector; the method being further **characterised by** the following steps of predicting an arrival position for emitted neutrons, by using a Monte Carlo method when a neutron source arranged at the ex-core detector and neutrons emitted towards the nuclear reactor core, the predicted arrival position indicating where the emitted neutron will arrive at the nuclear reactor core; and

    producing an SAF based on a correlation between the neutron source arranged at the ex-core detector and the predicted arrival position of the neutrons.

2.  The computer-implemented method of claim 1, wherein, in the 3-dimentionally modeling of the elements wherein a plurality of ex-core detectors are disposed in the nuclear reactor cavity,
    one of the plurality of ex-core detectors is disposed at each of an upper portion, a middle portion, and a lower portion of the nuclear reactor cavity, in a vertical direction of the nuclear reactor core,
    predicting of the arrival position for the emitted neutrons is performed for the ex-core detectors disposed at each of the upper portion, the middle portion, and the lower portion of the nuclear reactor cavity, and
    the nuclear reactor core is divided into a plurality of slices in a horizontal direction and it is predicted on which slice the emitted neutrons will arrive.


**Patentansprüche**

1.  Computerimplementiertes Verfahren zum Reduzieren von Fehlern, wenn eine Formglühfunktion (shape annealing function, SAF) von einem Detektor außerhalb des Reaktorkerns eines Kernkraftwerks berechnet wird, wobei das Verfahren Folgendes umfasst:

    3-dimensionales Modellieren von Elementen des Kernkraftwerks, wobei die Elemente des Kernkraftwerks Folgendes umfassen:

    einen Reaktorkern,
    einen Detektor außerhalb des Reaktorkerns, der in einer Reaktorgrube angeordnet ist, und
    Reaktorstrukturen, die zwischen dem Reaktorkern und dem Detektor außerhalb des Reaktorkerns angeordnet sind;
    wobei das Verfahren ferner durch die folgenden Schritte gekennzeichnet ist:

    Voraussagen einer Ankunftsposition für emittierte Neutronen unter Verwendung einer Monte-Carlo-Methode, wenn eine Neutronenquelle an dem Detektor außerhalb des Reaktorkerns angeordnet ist und Neutronen zu dem Reaktorkern emittiert werden, wobei die vorausgesagte Ankunftsposition angibt, wo das emittierte Neutron an dem Reaktorkern ankommen wird; und
    Herstellen einer SAF basierend auf einer Korrelation zwischen der Neutronenquelle, die an dem Detektor außerhalb des Reaktorkerns angeordnet ist, und der vorausgesagten Ankunftsposition der Neutronen.

2.  Computerimplementiertes Verfahren nach Anspruch 1, wobei in dem 3-dimensionalen Modellieren der Elemente,
    eine Vielzahl von Detektoren außerhalb des Reaktorkerns in der Reaktorgrube angeordnet sind,
    einer der Vielzahl von Detektoren außerhalb des Reaktorkerns an jedem eines oberen Abschnitts, eines mittleren Abschnitts und eines unteren Abschnitts der Reaktorgrube angeordnet ist,
    ein Voraussagen der Ankunftsposition für die emittierten Neutronen für die Detektoren außerhalb des Reaktorkerns, die an jedem des oberen Abschnitts, des mittleren Abschnitts und des unteren Abschnitts der Reaktorgrube angeordnet sind, durchgeführt wird, und

der Reaktorkern in eine Vielzahl von Teilen in einer horizontalen Richtung aufgeteilt ist, und vorausgesagt wird, an welchem Teil die emittierten Neutronen ankommen werden.

**Revendications**

1. Procédé informatique de réduction d'erreurs lors du calcul d'une fonction de recuit de forme (SAF) d'un détecteur ex-core d'une centrale d'énergie nucléaire, le procédé comprenant :

   des éléments de modélisation en 3 dimensions de la centrale d'énergie nucléaire, les éléments de la centrale d'énergie nucléaire comprenant :

   un coeur de réacteur nucléaire,
   un détecteur ex-core disposé dans une cavité de réacteur nucléaire, et
   des structures de réacteur nucléaire agencées entre le coeur de réacteur nucléaire et le détecteur ex-core ;
   le procédé étant en outre **caractérisé par** les étapes suivantes de
   prédiction d'une position d'arrivée pour des neutrons émis, au moyen de la méthode de Monte Carlo lorsqu'une source de neutrons est agencée au niveau du détecteur ex-core et des neutrons sont émis vers le coeur de réacteur nucléaire, la position d'arrivée prédite indiquant où le neutron émis arrivera au niveau du coeur de réacteur nucléaire ; et

   production d'une SAF en fonction d'une corrélation entre la source de neutrons agencée au niveau du détecteur ex-core et de la position d'arrivée prédite des neutrons.

2. Procédé informatique selon la revendication 1, dans lequel, dans la modélisation en 3 dimensions des éléments une pluralité de détecteurs ex-core est disposée dans la cavité de réacteur nucléaire, un de la pluralité de détecteurs ex-core est disposé au niveau de chacune d'une partie supérieure, d'une partie médiane et d'une partie inférieure de la cavité de réacteur nucléaire, dans un sens vertical du coeur du réacteur nucléaire,
la prédiction de la position d'arrivée pour les neutrons émis est réalisée pour les détecteurs ex-core disposés au niveau de chacune d'une partie supérieure, d'une partie médiane et d'une partie inférieure de la cavité de réacteur nucléaire, et
le coeur de réacteur nucléaire est divisé en une pluralité de tranches dans un sens horizontal et on prédit sur quelle tranche les neutrons émis arriveront.

# FIG. 1

NUCLEAR REACTOR CAVITY

50

60

II

EX-CORE DETECTOR

70

PRESSURE VESSEL

DOWN STREAM PATH

SHROUD

3-DIMENSIONAL EFFECT

NUCLEAR REACTOR CORE

CORE SUPPORT BARREL

II

10    20    30    40

EP 2 613 325 B1

# FIG. 2

9

# FIG. 3

# FIG. 4

FIG. 5

**EP 2 613 325 B1**

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020120002462
- US 2010104059 A1